# EUROPEAN PATENT APPLICATION

(11) **EP 4 529 407 A1**
(43) Date of publication of application: **26.03.2025**
(21) Application number: 23199083.9
(22) Date of filing: 22.09.2023
(51) Int. Cl.: H10N 70/00, H10N 70/20, G11C 11/22

(54) **A MEMORY STRUCTURE AND A METHOD OF FABRICATING A MEMORY STRUCTURE**

(71) Applicant: Huawei Technologies Co., Ltd., Shenzhen, Guangdong 518129 (CN)
(72) Inventor: Muller, Philippe, 80992 Munich (DE); Barci, Marinela, 80992 Munich (DE)
(74) Representative: Grindl, Wolfgang

(57) **Abstract**

The present disclosure relates to a memory structure (10) and to a process for fabricating a memory structure (10). The memory structure (10) comprises: a substrate (11); an electrode pair (12-1, 12-2) which is arranged on the substrate (11); and a metamaterial structure which is arranged between the electrodes of the electrode pair (12-1, 12-2); wherein the metamaterial structure (13) comprises at least two different materials (14, 15) which are alternately arranged in a periodic pattern. The metamaterial structure (13) is electrically excitable to two different memory states due to at least one of its at least two materials (14, 15) undergoing an at least partially reversible change of its structural and/or electrical properties in dependence of a bias voltage being applied to the electrode pair (12-1, 12-2).

## Description

### TECHNICAL FIELD

The present disclosure relates to a memory structure and to a method of fabricating a memory structure.

### BACKGROUND

In advanced node semiconductors, new memory components are developed to fulfill the increasing requirements of new applications, such as machine learning, neuromorphic, low power or IoT applications. The main non-volatile emerging memory candidates are RRAM, PCM, MRAM and FeRAM.

Most of these technologies are composed of metal-insulator-metal structures, where an insulator is sandwiched between two electrodes. The main operations to switch the device are SET and RESET operations (or ON-state and OFF-state) corresponding to a low resistive state (or bit 0) and a high resistive state (or bit 1) of the insulator. For instance, defects may form in the insulator material during the low resistive state and are dissolved in the high resistive sate. During operation, the devices can be cycled many times between the high resistance state (HRS) and the low resistance state (LRS), wherein the number of rewriting cycles is often referred to as endurance.

However, non-volatile emerging memories often experience HRS degradation over time and over endurance cycling. For example, after a RESET operation (i.e., in OFF-state) a dissolution of defects in the insulator material may be incomplete (so-called virtual cathode), which in-turn reduces the resistivity in the HRS. The number of such remaining defects in the OFF-sate can increase with each cycling, thereby gradually degrading the device performance and reliability.

So far, attempts to improve the performance of such memories mostly consist of studying different insulator materials, as well as tuning the electrodes and film thicknesses. However, it is difficult to achieve the desired high reliability specifications.

### SUMMARY

In view of the above, this disclosure aims to provide an improved memory structure and an improved method of fabricating a memory structure, which overcome the abovementioned limitations and disadvantages.

These and other objectives are achieved by the solution of this disclosure as described in the independent claims. Advantageous implementations are further defined in the dependent claims.

The disclosure is based on the following considerations:
In some non-volatile memory devices, such as RRAM, FeRAM or PCM devices, the performance of the memory devices (e.g., switching speed, power consumption, cycling or retention) can be improved by using bilayers or similar structures.

In RRAM devices, the memory performance can be improved combining two metal oxides with different band gaps and dielectric coefficients. Thereby, one oxide can provide memory operations and the other oxide can act as interfacial layer. For example, the addition of a thin metal-oxide layer (e.g., 0.5 nm-thick Al₂O₃) in a bottom of a GdOx memory stack may significantly increase an R_{OFF} and a memory window (e.g., by more than one decade), and improve an endurance performance (up to 10⁵ cycles) with respect to a monolayer CBRAM device (1e4 cycles).

Furthermore, in RRAM devices, certain RRAM materials could enable neuromorphic computing to reproduce synapse like operations. For instance, adding two or more dielectrics could closely mimic synapses with different neurotransmitters. Materials, such as PCMO, HfOx, TaOx, TiOx, NiOx, WOx, or AlOx, could be used in oxide-based synaptic devices.

FeRAM memory devices can be adapted by interfacial oxide engineering, e.g. adding both a 1 nm TiO₂ seed layer and a 2nm NbzOs cap layer to an La:HZO layer. In this way, high endurance can be achieved (up to 10¹¹ cycles) in combination with a final 2P_{R} as high as ~30µC/cm² (at an applied electric field of 1.8 MV/cm) and a favorable initial 2P_{R}.

MRAM devices may comprise structures with additional layers to reduce a switching current and cell size. The most promising structure therefore is a double spin-torque magnetic tunnel junction (DS-MTJ), which can add a non-magnetic (NM) spacer (SP) and a reference layer on top of the conventional MTJ. This can improve the magnetic memory properties.

Furthermore, an MRAM device could comprise a magnetic tunnel junction as the main component, which can be composed of CoFeB/MgO layers. By incorporating a bilayer structure composed of an AlOx/MgO nanolaminate film, an improvement of the hydroscopicity of the film in big area MTJ can be achieved, resulting in improved magnetic properties of the device.

A PCM device may comprise a single-phase change material (PCM) pack surrounding a payload which is subsequently surrounded by an insulation layer (bilayer configuration). By changing the configuration into two bilayers, which is a series of PCM and insulation pairs, a significant advantage can be achieved in terms of the total time for which the payload stays at a desired frozen temperature.

A commonality among these considerations is the use of memory structures with more complex geometries and/or multiple materials to improve the memory performance.

A first aspect of this disclosure provides a memory structure, comprising: a substrate; an electrode pair which is arranged on the substrate; and a metamaterial structure which is arranged between the electrodes of the electrode pair; wherein the metamaterial structure comprises at least two different materials which are alternately arranged in a periodic pattern; and wherein the metamaterial structure is electrically excitable to two different memory states due to at least one of its at least two materials undergoing an at least partially reversible change of its structural and/or electrical properties in dependence of a bias voltage being applied to the electrode pair.

This provides the advantage that a memory structure is provided which experiences less degradation due to its metamaterial structure. This can enhance memory device reliability in terms of thermal stability and endurance. At the same time, memory device electrical performances like leakage and retention can be optimized.

For instance, the memory structure is an RRAM structure, wherein the periodic arrangements of the materials facilitate a dissolution of defects and/or conductive filaments in a high resistive state (HRS) of the memory structure, and thus increase the resistance in this state.

For example, the structural and/or electrical change in the material(s) of the metamaterial structure is induced by applying different bias voltages to the electrode pair. For instance, a positive bias voltage is applied to the top and a zero bias or GND (ground) is applied to the bottom electrode for an SET operation and the polarity is reversed (negative bias to the top electrode and zero bias to the bottom electrode) for a RESET operation. Thereby, the SET operation can induce a change to a low resistance state (LRS), while the RESET operation can induce a change to a high resistance state (HRS).

At least one of the materials of the metamaterial structure can be configured to change its electrical resistance, its polarization, its magnetic properties and/or its structural properties (e.g., crystalline structure, formation/distribution of defects etc.) in dependence of the bias voltage being applied to the electrode pair.

The memory structure can be a resistive random-access memory (RRAM), a ferroelectric random-access memory (FeRAM), a magnetoresistive random access memory (MRAM), or a phase-change random access memory (PCM) structure or device (or a part thereof). It can be fabricated with a low-cost fabrication method and can reduce the leakage and enhance thermal stability of the structure and better cycling endurance properties by its metamaterial structure.

In an implementation form of the first aspect, the metamaterial structure comprises a layer stack of at least two layers, wherein each layer of the layer stack comprises a one-dimensional or two-dimensional pattern of the at least two materials. The periodic pattern of each layer can be a one-dimensional pattern (e.g., a line pattern) or a two-dimensional pattern.

This achieves the advantage that the metamaterial structure can comprise a complex three-dimensional periodic pattern, which can be generated by successively deposing layers with periodic patterns on top of each other. For example, each layer of the layer stack can comprise a line pattern, i.e., alternating lines of the first and second material.

In an implementation form of the first aspect, each two successive layers of the layer stack are offset from each other and/or rotated to each other with respect to their patterns.

This can cause a horizontal displacement of areas with the same material in subsequent layers, resulting in a metamaterial structure with a pattern that is periodic in a (vertical) direction from electrode to electrode (i.e., a stacking direction of the layers).

The resulting metamaterial structure may comprise different shapes and patterns, e.g. complex 2D or 3D periodic structures. The metamaterial structure may comprise nano-scaled interdigitated patterns, such as lines, squares or more complex structures. The periodic structuration of the different metamaterial layers can help to confine conduction and/or phase change mechanisms, resulting in faster response times and longer data retention in a memory cell.

In an implementation form of the first aspect, the at least two materials of the metamaterial structure are dielectric materials.

In an implementation form of the first aspect, the at least two materials of the metamaterial structure comprise a metal oxide material and/or a silicon nitride material.

The at least two materials of the metamaterial structure may comprise any one of the following materials: AlOx, HfOx, ZrOx, SiON, SiNx, BaSrTiO3, or graphene nano-flake-containing polymeric materials.

In an implementation form of the first aspect, only one of the at least two materials of the metamaterial structure undergoes the at least partially reversible change of its structural and/or electrical properties in dependence of the bias voltage being applied to the electrode pair.

For instance, the metamaterial structure comprises a metal oxide material which undergoes the change of its structural and/or electrical properties and a silicon nitride material which does not undergo such a change of its structural and/or electrical properties, wherein the metal oxide materials and the silicon nitride material are alternately arranged in the periodic pattern.

In an implementation form of the first aspect, the at least partially reversible change of its structural and/or electrical properties in the at least one of the at least two materials comprises a formation and/or an interconnection of conducting filaments in the material.

For instance, the presence or absence of the conducting filaments and/or their interconnection may influence an electrical resistance of the metamaterial structure. Hereby, interconnection of filaments may refer to an overlap of the filaments, resulting in a formation of a conductive path.

The filaments can be formed by defects in the material, for instance oxide vacancies. Alternative to the formation of filaments, the reversible structural and/or electrical change can comprise a phase change, a crystallization, or a polarization change in the at least one material.

In an implementation form of the first aspect, the conducting filaments form a path between the electrodes of the electrode pair, wherein in a first memory state of the two memory states of the metamaterial structure, the path is continuous, and in a second memory state of the two memory states of the metamaterial structure, the path is interrupted and/or at least partially dissolved.

In an implementation form of the first aspect, each section of the at least one of the at least two materials of the metamaterial structure is arranged to overlap with at least one adjacent section of the same material, such that the continuous path extends from one electrode of the electrode pair to the other electrode of the electrode pair.

For instance, the continuous path only passes through sections of the metamaterial structure which are formed from the material which undergoes the reversible change of its structural and/or electrical properties.

The material, which undergoes the structural and/or electrical change, can be a metal oxide (MOx). Each section of the MOx material in the metamaterial structure can be arranged to overlap with adjacent MOx sections, such that the continuous path can extend from electrode to electrode (especially in the first memory state). Due to this confinement, a creation of a virtual cathode or remaining filaments can be avoided in the second memory state, which can cause a reduction of programming parameters and energies by up to a factor of 4.

In an implementation form of the first aspect, the two memory states of the metamaterial structure are associated with two different electrical resistances of the metamaterial structure.

This achieves the advantage that the memory structure can be a resistive RAM structure which experiences a significantly reduced degradation over time due to its metamaterial structure.

A second aspect of this disclosure provides a method of fabricating a memory structure, comprising the steps of: forming a first electrode of an electrode pair on a substrate; forming a metamaterial structure on the first electrode, wherein the metamaterial structure comprises at least two different materials which are alternately arranged in a periodic pattern; and forming a second electrode of the electrode pair on the metamaterial structure; wherein the metamaterial structure is electrically excitable to two different memory states due to at least one of its at least two materials undergoing an at least partially reversible change of its structural and/or electrical properties in dependence of a bias voltage being applied to the electrode pair.

This provides the advantage that a memory structure is provided which experiences less degradation due to its metamaterial structure. The memory structure can be fabricated by a relatively low-cost nanoscale patterning process.

The periodic pattern of the metamaterial structure can be generated by means of a nanoimprint or EUV lithography technique.

In an implementation form of the second aspect, the metamaterial structure is formed by a stacking of layers, wherein each layer comprises a one-dimensional or two-dimensional pattern of the at least two materials. The periodic pattern of each layer can be a one-dimensional or a two-dimensional pattern.

For instance, the layers of the metamaterial structure can be formed by perpendicular successive prints, which can reduce overlay (OVL) requirements.

In an implementation form of the second aspect, each two successive layers are offset from each other and/or rotated to each other with respect to their patterns.

In an implementation form of the second aspect, each layer is formed by: depositing a uniform layer of one material of the at least two materials; patterning the uniform layer to generate periodic gaps in the layer; and filling the periodic gaps with a further one of the at least two materials.

The patterning of the metamaterial structure can be generated by a nanoimprint or EUV lithography. Subsequent a dry-etching can be carried out
In an implementation form of the second aspect, the metamaterial structure and the second electrode are subsequently formed on the first electrode. This achieves the advantage that the memory structure can efficiently be fabricated via a direct integration process on a single substrate.

For instance, the metamaterial structurer can directly be grown, deposited and patterned on the substrate if the growth-process is compatible with the substrate in terms of thermal budget, substrate orientation, crystal lattice size and/or other requirements.

In an implementation form of the second aspect, the metamaterial structure and the second electrode are formed on a further substrate and subsequently transferred to the substrate by means of a wafer bonding step. This achieves the advantage that the memory structure can efficiently be fabricated using a layer transfer technique.

After said bonding, the further substrate can be released, e.g. by using CMP or dry etching.

In an implementation form of the second aspect, the at least two materials of the metamaterial structure are dielectric materials.

In an implementation form of the second aspect, the at least two materials of the metamaterial structure comprise a metal oxide material and/or a silicon nitride material.

In an implementation form of the second aspect, only one of the at least two materials of the metamaterial structure undergoes the at least partially reversible change of its structural and/or electrical properties in dependence of the bias voltage being applied to the electrode pair.

In an implementation form of the second aspect, the at least partially reversible change of its structural and/or electrical properties in the at least one material comprises a formation and/or an interconnection of conducting filaments in the material.

In an implementation form of the second aspect, the conducting filaments form a path between the electrodes of the electrode pair, wherein in a first memory state of the two memory states of the metamaterial structure, the path is continuous, and in a second memory state of the two memory states of the metamaterial structure, the path is interrupted and/or at least partially dissolved.

In an implementation form of the second aspect, each section of the at least one material in the metamaterial structure is arranged to overlap with at least one adjacent section of the same material, such that the continuous path extends from one electrode of the electrode pair to the other electrode of the electrode pair.

In an implementation form of the second aspect, the two memory states of the metamaterial structure are associated with two different electrical resistances of the metamaterial structure.

The memory structure according to the first aspect of the disclosure can be fabricated by the method according to the second aspect of the disclosure.

### BRIEF DESCRIPTION OF DRAWINGS

The above described aspects and implementation forms will be explained in the following description of specific embodiments in relation to the enclosed drawings, in which:
- FIG. 1: shows a schematic diagram of a memory structure according to an embodiment of this disclosure;
- FIGS. 2A-B: show a comparison between a conventionally designed memory structure and a memory structure according to an embodiment of this disclosure;
- FIGS. 3A-L: show a process flow of a method for fabricating a memory structure according to an embodiment of this disclosure; and
- FIGS. 4A-K: show a process flow of a method for fabricating a memory structure according to an embodiment of this disclosure.

### DETAILED DESCRIPTION OF EMBODIMENTS

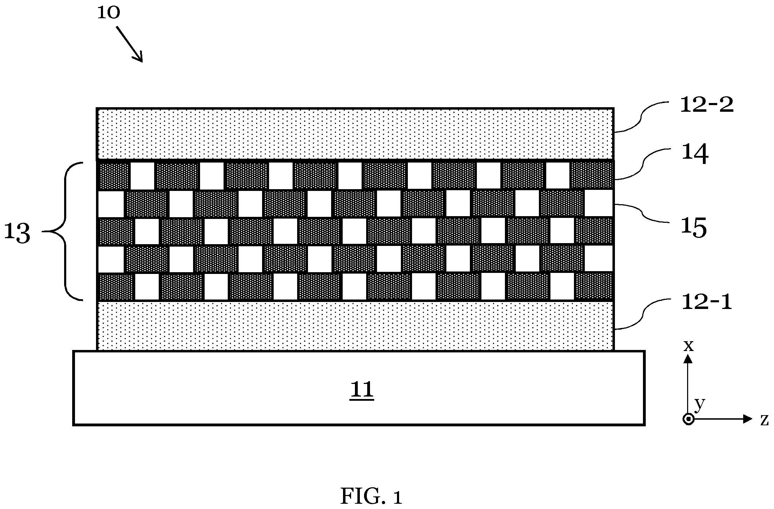

FIG. 1 shows a schematic diagram of a memory structure according to an embodiment of this disclosure.

The memory structure 1 comprises a substrate 11; an electrode pair 12-1, 12-2 which is arranged on the substrate 11; and a metamaterial structure 13 which is arranged between the electrodes of the electrode pair 12-1, 12-2; wherein the metamaterial structure 13 comprises at least two different materials 14, 15 which are alternately arranged in a periodic pattern. The metamaterial structure 13 is electrically excitable to two different memory states due to at least one of its at least two materials 14, 15 undergoing an at least partially reversible change of its structural and/or electrical properties in dependence of a bias voltage being applied to the electrode pair 12-1, 12-2.

The memory structure 10 can be or can form a memory device, for instance an RRAM (also: ReRAM), an MRAM, a FeRAM or a PCM device, or a component thereof. As such, one, more or all of the materials of the metamaterial structure can be configured to adapt their electrical resistance, their polarization, their magnetic properties and/or their structural properties (e.g., crystalline structure, formation/distribution of defects, insulator-to-metal transition etc.) in dependence of the bias voltage being applied to the electrode pair.

To electrically excite the memory structure 10 to a first or a second memory state of the two different memory states, a positive or a negative bias can be applied to the electrode pair 12-1, 12-2.

The two memory states of the metamaterial structure 13 and, in particular, of the memory structure 10 can be associated with two different electrical resistances of the metamaterial structure 13.

For example, a positive bias voltage is applied to the top and a zero bias or ground (GND) voltage is applied to the bottom electrode for a SET operation, i.e., setting the memory structure 10 to an ON state. The ON state can be a low resistive state (LRS) in which the metamaterial structure 13 has a low electrical resistance. This ON state may represent a "0 bit". The polarity can be reversed (e.g., negative bias on top electrode and zero bias on bottom electrode) for a The RESET operation, i.e., setting the memory structure 10 to an OFF state. The OFF state can be a high resistive state (HRS) in which the metamaterial structure 13 has a high electrical resistance. This OFF state may represent a "1 bit".

By using the metamaterial structure 13, the HRS of the memory structure 10 can be improved and the endurance can be extended beyond 1E6 cycles. The metamaterial structure 13 has fewer defects and a lower bias response during HRS, resulting in reduction of defect-vacancies such as virtual cathode or inter-diffusion (lateral and towards the electrodes).

In general, metamaterials are a type of artificially engineered materials which exhibit desired electrical and/or optical properties depending on their microarchitectures (e.g., process manufacturing, geometry, programming parameters and testing instruments). Their constituent "metaparticles" are composed of molecules, atoms and subatomic particles. However, it is the larger-scale geometry, orientation and arrangement of these metaparticles that determine the essential macroscopic properties of the metamaterial.

In general, a metamaterial is an artificially manufactured structure which is engineered to have certain physical properties that are typically not observed in naturally occurring materials, e.g. certain electrical, structural or optical properties. Typically, metamaterials comprise multiple elements or materials which are arranged in repeating patterns.

The metamaterial structure 13 used in the memory structure 10 may comprise one or more material properties which are obtained from a modified material stack deposition, a specific device geometry and/or advanced programming schemes. The metamaterial structure 13 can form a memory stack which is compatible with advanced applications such as AI, IoT, in-memory quantum computing, neuromorphic systems and mobile devices. It can also be integrated in a 3D stacked chip in the BEOL (back end of line).

For example, the metamaterial structure 13 of the memory structure 10 may comprise a layer stack of at least two layers, wherein each layer of the layer stack comprises a periodic 1D or 2D pattern of the at least two materials 14, 15. For instance, each layer comprises a pattern with a periodicity in one or two spatial directions perpendicular to a stacking direction of the layers (e.g., a periodicity in y- and/or z-direction, wherein the layers are stacked in x-direction, as indicated by the Cartesian coordinate system in FIG. 1). In the example shown in FIG. 1, the layer stack comprises four layers.

As can be seen in FIG. 1, which shows a side view of the memory structure 10, each two successive layers of the layer stack can be offset from each other with respect to their two-dimensional patterns. Each two layers may also be rotated to each other. This can cause a horizontal displacement of areas with the same material in subsequent layers (horizontal refers to a direction parallel to the electrodes 12-1, 12-2). Thereby, every second layer may be aligned to each other, such that a repeating pattern is formed in a vertical direction (vertical refers to a stacking direction of the layers).

The at least two materials of the metamaterial structures can be dielectric materials. For example, the at least two materials 14, 15 of the metamaterial structure 13 may comprise at least one semiconductor oxide material, at least one metal oxide material and/or at least one high-k material. For instance, the at least two materials 14, 15 of the metamaterial structure 13 may comprise one or more of the following materials: SiₓO_{y}, SiₓN_{y}, SiCN, SiCO, SiON, GeₓO_{y}, HfOₓ, AlₓOy, TaₓOy, NbₓO_{y}, BaSrTiO₃, VO₂, insulating 2D materials (e.g., graphene), or nano-flake-containing polymeric materials.

The bottom and/or top electrode of the electrode pair 12-1, 12-2 can be formed by a conductive layer that can comprise one or more materials, such as metals (e.g, Ti, TiW, TiN, Ta, TaN, Ni, Pt, Nb, or others), 2D materials or composite materials.

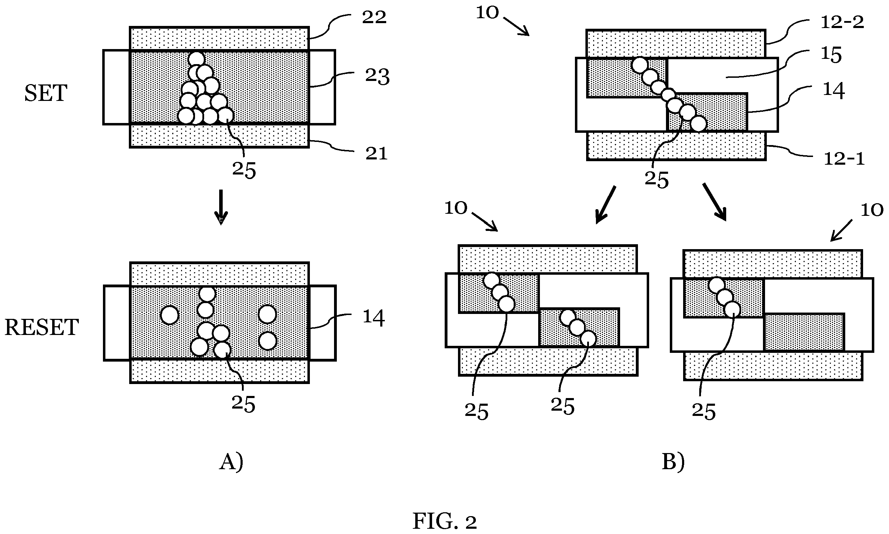

FIGS. 2A-B show a comparison between a conventionally designed memory structure (without an incorporated metamaterial) and a memory structure 10 with a metamaterial structure 13 according to an embodiment of this disclosure. Thereby, FIG. 2A shows the two memory states of the memory without the metamaterial and FIG. 2B shows the same memory states for the memory structure 10 with the metamaterial structure 13. Both memories can be based on an induced change of the electrical resistivity of a memory material between two electrodes.

In the memory structure shown in FIG. 2A, a single material 23, e.g. a metal oxide (MOx) or dielectric, is arranged between two electrodes 22, 23. The memory material 23 can further be sandwiched between two SiN layers in horizontal direction.

After performing a SET operation, e.g. by applying a positive bias on the top electrode 22 and GND on the bottom electrode 21 (e.g., 2-5V), a soft breakdown of the dielectric/MOx may occur and, as a consequence, conducting filaments 25 may form and/or interconnect which results in a conductive path through the metal oxide that connects the top and bottom electrodes 21, 22. This reduces the resistivity of the material 23 (low resistance state, or short: LRS).

The filaments 25 can be made of oxygen vacancies or metallic ions depending on the stack and/or materials implemented in the RRAM structure. For example, the filaments 25 can be formed by a redox mechanism due to the applied electric field which can cause a movement of: a) top electrode ions into the switching layer (dielectric, metal oxide) and deposited on the inert bottom electrode until they create a filament of metal atoms; or b) oxygen vacancies due to a soft breakdown of the switching layer (dielectric, metal oxide) induced by electric field.

After performing a RESET operation, e.g. by applying a negative bias on the top electrode 22 or a lower positive bias on the top electrode (e.g., 1-2V) and a GND or zero voltage to the bottom electrode 21, the filaments can be dissolved. This in-turn enhances the resistivity of the material 23 (high resistance state, or short: HRS).

However, as shown in the bottom drawing in FIG. 2A, the dissolution is often not complete as defects may remain in the memory material or part of the filament is not completely removed (so-called "virtual cathode"). The number of these remaining defects typically increases with each cycle, e.g., because the remaining defects make it easier to recreate the filament and drift effects are present during cycling. This can cause a degradation of the memory performance and reliability.

FIG. 2B shows the same memory states with a memory structure 10 comprising the metamaterial structure 13 between the two electrodes 12-1, 12-2. In the example shown in FIG. 2B, the metamaterial structure 13 comprises a metal oxide material 14 and a silicon nitride material 15 which are arranged in an alternating pattern.

Thereby, only one of the two materials 14, 15 of the metamaterial structure 13, namely the metal oxide material 14, undergoes the at least partially reversible change of its structural and/or electrical properties in dependence of the bias voltage being applied to the electrode pair 12-1, 12-2. The change of the structural and/or electrical properties that occurs in the metal oxide material 14 is again a formation and/or an interconnection of conducting filaments 25. The filaments 25 can be formed by defects in the material, for instance oxide vacancies.

After performing a SET operation, e.g. by applying a positive bias to the top electrode 22 and GND to the bottom electrode 21 (e.g., 2-5V), the conducting filaments 25 form a continuous path between the electrodes of the electrode pair 12-1, 12-2, which causes a reduction of the electrical resistance of the metamaterial structure (HRS). This can be facilitated by each section of the metal oxide material 14 being arranged to overlap with at least one adjacent section of the same material, such that the continuous path can extend through these overlapping sections from one electrode 12-1 to the other electrode 12-2 of the electrode pair.

In other words, the continuous path only passes through sections of the metamaterial structure 13 which are formed from the one material 14 which undergoes the reversible change of its structural and/or electrical properties.

After performing the RESET operation, e.g. by applying a negative bias or a lower positive bias on the top electrode (e.g., 1-2 V) and a GND or zero voltage to the bottom electrode 21, this continuous path can be fully interrupted and/or at least partially dissolved as shown in the bottom drawings in FIG. 2B. For instance, this interruption can be caused by a drift of the filaments 25 in the MOx material sections 14 (as shown in the bottom left drawing of FIG. 2B) or by a dissolution of the conductive filaments 25 in at least some of the MOx material sections 14 (as shown in the bottom right drawing of FIG. 2B). This interruption of the conductive path is greatly facilitated by the alternating arrangement of the materials 14, 15 of the metamaterial structure 13. For instance, a drift / dissolution of filaments in the overlapping sections of the MOx material 14 can be sufficient to fully interrupt the conductive path and enhance the resistivity of the metamaterial structure (HRS).

Thus, the metamaterial structure 13 can be a confined structure (i.e., a structure with confined material components), where a conductive path only occurs in the presence of one of the materials (e.g., MOx). As a consequence, a formation of a virtual cathode or remaining filaments 25 can be avoided. This can cause a reduction of programming parameters or energies by up to a factor of 4.

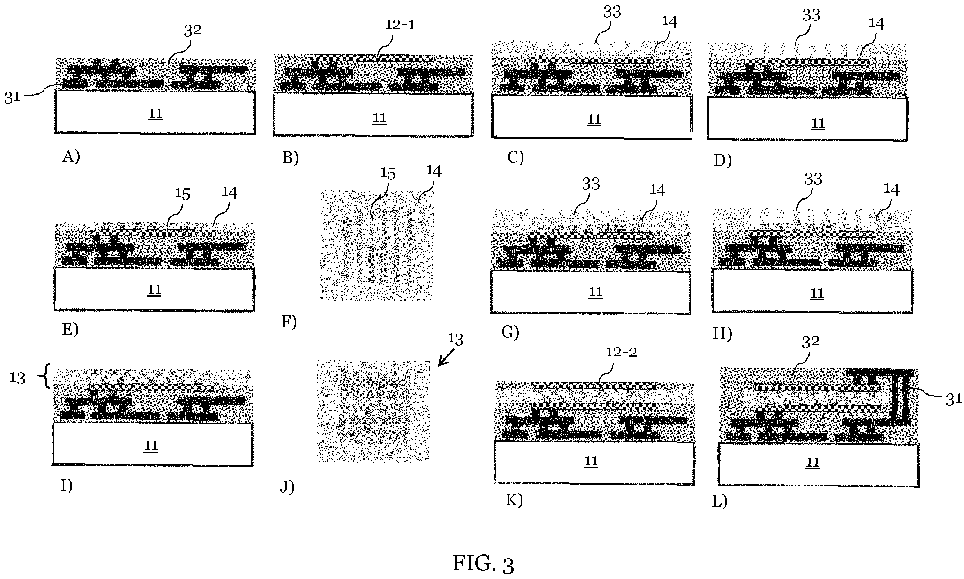

FIGS. 3A-L show a process flow of a method for fabricating the memory structure 10 according to an embodiment of this disclosure. In the embodiment shown in FIGS. 3A-L, the metamaterial structure 13 and the second electrode 12-2 are subsequently formed on the first electrode 12-1.

The method comprises a formation of the first electrode 12-1 of the electrode pair on the substrate 11. The substrate 11 can be a device wafer which contains active devices and interconnects in a BEOL, for instance metal (e.g., Cu) lines 31 in an interlayer dielectric (ILD) 32, as shown in FIG. 3A.

The first (bottom) electrode 12-1 can be deposited and patterned by a Damascene process, as shown in FIG. 3B. This bottom electrode 12-1 can comprise a conductive layer that can be composed of multiple materials such as metals (e.g., Ti, TiW, TiN, Ta, TaN, Ni, Pt, Nb), 2D materials or composite materials. Various deposition techniques can be used to fabricate the bottom electrode 12-1, such as spin-on, PLD, DIBS, RID, ECD, ELD, PVD, CVD, ALD, EBeam evaporation MBE, or MOCVD.

In subsequent steps of the method, shown in FIGS. 3C-J, the metamaterial structure 13 is formed on the first electrode 12-1, wherein the metamaterial structure 13 comprises at least two different materials 14, 15 which are alternately arranged in a periodic pattern.

The metamaterial structure 13 can thereby be formed by a stacking of layers, wherein each layer may comprise a periodic pattern (e.g., a 1D or 2D pattern) of the at least two materials 14, 15. As shown in FIG. 3C-E, each layer can be formed by: depositing a uniform layer of one material 14 of the at least two materials; patterning the uniform layer to generate periodic gaps in the layer; and filling the periodic gaps with a further one 15 of the at least two materials.

For instance, a first dielectric or insulating layer of a first material 14 can be deposited on the bottom electrode 12-1. This layer can be realized by various deposition techniques, such as spin-on, PLD, DIBS, RID, ECD, ELD, PVD, CVD, PECVD, ALD, EBeam evaporation MBE, MOCVD. This dielectric or insulating layer can comprise a single or multi-layered / nanolaminate structure. It can comprise any one of the following materials: semiconductor oxides (e.g., SixOy, SixNy, SiCN, SiCO, GexOy, etc.), metal oxide or high-k materials (e.g., AlxOy, TaxOy, NbxOy, etc.), or insulating 2D materials (e.g., graphene).

Once this first dielectric or insulating layer is deposited and eventually annealed, an etch-mask 33 can be deposited as shown in FIG. 3C. The etch mask 33 can be a hard or soft mask using a photosensitive or imprint material to transfer a mask pattern directly to the layer stack of the metamaterial structure 13 or to a first hard-mask. Once the patterns are transferred, e.g. using an eBeam, laser, eUV, or DUV lithography or nanoimprint technique, an etching step can be performed to remove parts of the first dielectric or insulator layer, stopping at the bottom electrode 12-1, as shown in FIG. 3D.

The etch mask 33 can subsequently be stripped and a second material 15 layer can be deposited with the same set of techniques as for the first layer. The second material 15 can thereby be deposited in the gaps formed in the first material 14. A subsequent planarization step can be performed either by plasma etch back or by CMP before or after an annealing step (FIG. 3E).

FIG. 3F shows a top view of a resulting first layer of the metamaterial structure 13 which comprises a line-pattern (i.e., alternating lines of the first and the second material 14, 15).

This process can be repeated with another dielectric or insulator layer that can comprise the same material(s) as the first dielectric or insulator material layer.

The same patterning and deposition sequence can be performed on the second material layer, as shown in FIGS. 3G-I. The, so generated patterns of the first and second layer of the metamaterial structure 13 can be aligned in such a way that a periodic heterogeneous material in x, y and z directions is generated. For example, each two successive layers of the metamaterial structure can be offset from each other and/or rotated to each other (e.g., by 90°) with respect to their patterns.

The FIGS. 3G-I show an example of two layers each comprising a line pattern of two materials 14, 15 arranged perpendicular to each other. Other periodic patterns and shapes could be formed in this way, such as squares, honey-combs, and round or other shapes. This can be repeated corresponding to the requirements. FIG. 3J shows a top view of a resulting patterning of the metamaterial structure 13.

In a subsequent step, shown in Fig. 3K, the second electrode 12-2 of the electrode pair is formed on the metamaterial structure 13. The second electrode 12-2 can again be formed by a damascene process or direct patterning which can be followed by further steps, such as via and interconnect 31 formation, an optional metamaterial 13 side etching, a planarization and/or a formation of top metal connections, as shown in FIG. 3L.

The so generated metamaterial structure 13 is electrically excitable to two different memory states due to at least one of its at least two materials 14, 15 undergoing an at least partially reversible change of its structural and/or electrical properties in dependence of a bias voltage being applied to the electrode pair 12-1, 12-2.

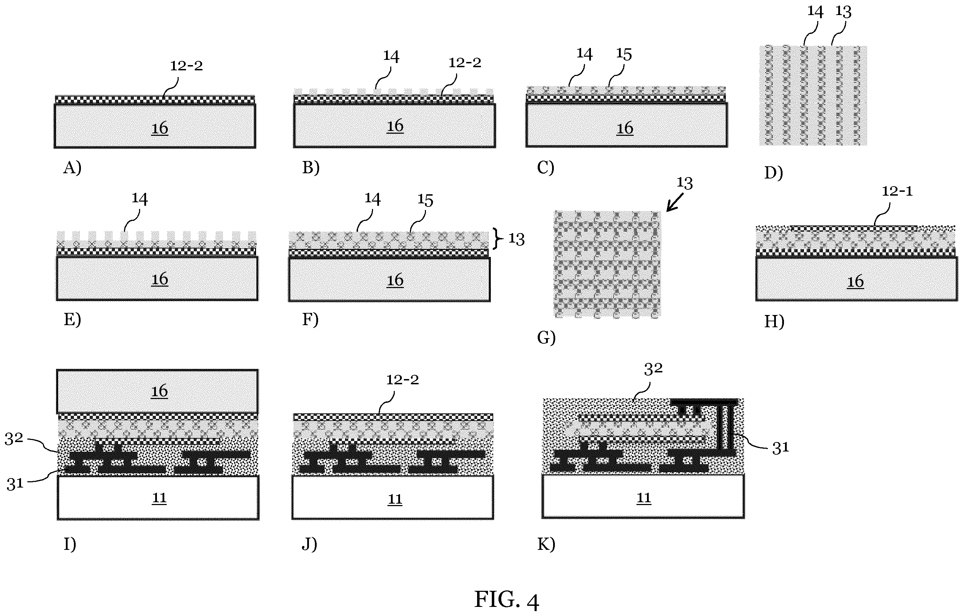

FIGS. 4A-K show a process flow of a method for fabricating the memory structure 10 according to an embodiment of this disclosure. In the embodiment shown in FIGS. 4A-K, the metamaterial structure 13 and the second electrode 12-2 are formed on a further substrate 16 and subsequently transferred to the substrate 11, e.g. on top or inside its BEOL, by means of a wafer bonding step.

The further substrate 16 can be a carrier wafer, e.g. made of silicon or any other dielectric or semiconductor material, or a metallic substrate that is suitable to achieve a proper growth of the metamaterial structure 13.

In a first step of the method, shown in FIG. 4A, the second electrode 12-2 can be deposited on the further substrate 16. This electrode 12-2 forms can comprise a conductive layer that can be composed of multiple materials such as metals (e.g., Ti, TiW, TiN, Ta, TaN, Ni, Pt, Nb), 2D materials or composite materials. Various deposition techniques can be used to fabricate the bottom electrode 12-1, such as spin-on, PLD, DIBS, RID, ECD, ELD, PVD, CVD, ALD, EBeam evaporation MBE, or MOCVD. The electrode (layer) 12-2 can comprise or be formed on a release layer (e.g., SiCN, TiN or SiCN) for later debonding. The electrode 12-2 typically remains unpatterned.

Subsequently, as shown in FIG. 4B, the first layer, e.g. a dielectric or insulating layer, of the metamaterial structure, can be deposited on the electrode 12-2. This layer can be realized by various deposition techniques, such as spin-on, PLD, DIBS, RID, ECD, ELD, PVD, CVD, PECVD, ALD, EBeam evaporation MBE, or MOCVD. This layer can comprise a single or multi-layered / nanolaminate material such as semiconductor oxide materials (e.g, SixOy, SixNy, SiCN, SiCO, GexOy, etc), metal oxide or high-k materials (e.g., AlxOy, TaxOy, NbxOy, etc), or insulating 2D materials (e.g., graphene).

After deposition of the first dielectric or insulating layer, an etch-mask 33 can be deposited on top (analogous to the etch mask deposition in FIG. 3C). The etch-mask can again be a hard or soft mask using a photosensitive or imprint material to transfer a mask pattern directly to the layer stack of the metamaterial structure 13 or to a first hard-mask. The print on the etch mask can cover a full reticle or the full wafer size (e.g., rolling nanoimprint). Once the patterns are transferred, e.g. using an eBeam, laser, eUV, or DUV lithography or a nanoimprint technique, an etching step can be performed to remove parts of the first dielectric or insulator layer, stopping at the bottom electrode 12-1, as shown in FIG. 4B.

The etch mask can subsequently be stripped and a second material 15 layer can be deposited with the same set of techniques as for the first layer. The second material 15 can thereby be deposited in the gaps formed in the first material 14. A subsequent planarization step can be performed either by plasma etch back or by CMP before or after an annealing step (FIG. 4C).

FIG. 4D shows a top view of a resulting first layer of the metamaterial structure 13 on the further substrate (e.g., carrier wafer) 16. This first layer comprises a line-pattern of the two materials 14, 15 (similar to line pattern in FIG. 3F).

This process can be repeated with another dielectric or insulator material layer that can comprise the same material(s) as the first dielectric or insulator material layer.

The same patterning and deposition sequence can be performed on the second material layer, as shown in FIGS. 4E-G. The so generated patterns of the first and second layer of the metamaterial structure 13 can be aligned in such a way that a periodic heterogeneous material in x, y and z directions is generated. For example, each two successive layers of the metamaterial structure can be offset from each other and/or rotated to each other (e.g., by 90°) with respect to their patterns.

The FIGS. 4F-G show an example of two layers of each two materials 14, 15 using perpendicular patterning lines. Other periodic patterns or shapes could be formed, such as squares, honey-combs, and round or other shapes. This can be repeated corresponding to the requirements. FIG. 4G shows a top view of a resulting patterning of the metamaterial structure 13.

The first electrode and/or a capping metallic layer can then be deposited on the metamaterial structure 13 before the layer transfer is performed, as shown in FIG. 4H.

The metamaterial structure 13, which can be wafer scale or panel-scale, as well as the first and/or second electrode 12-1, 12-2 can then be transferred to the substrate 11 (e.g., a target wafer) via a wafer-to-wafer (W2W) or a die-to-wafer(D2W) bonding process, as shown in FIG. 4I. Thereby, a temporary carrier/tape frame can be used to enable the removal of the further substrate 16, as shown in FIG. 4J.

Alternatively, the first electrode 12-1 can also be formed on the substrate 11 (e.g. patterned by damascene process), wherein during wafer bonding the metamaterial structure 13 (supported by the growth substrate or a temporary substrate such as a tape frame) is transferred to the first electrode 12-1 on the substrate 11.

After the bonding, the supporting substrate 16 can be removed by mechanical methods (e.g., grinding, CMP, diamond edge cutting, IR laser, etc.) or etching methods (plasma dry etching, wet chemical etching, vapor chemical etching, ion-milling, electro-erosion, etc.), as shown in FIG. 4J.

If the second (top) electrode 12-2 is not transferred from the further substrate 16 together with the metamaterial structure 13, it can be deposited and patterned in a subsequent step
Subsequently, the device boundaries can be defined and etched, e.g., via an optional metamaterial side etching, prior to an encapsulation in multiple dielectric stacks to prevent oxygen diffusion and provide planarization. Subsequent interconnects 31, vias and/or metal layers can be processed, e.g., in a Damascene or double Damascene process flow to generate electrical connections with device circuits on the substrate 11, as shown in FIG. 4K.

The memory structure 10 may be comprised by a processor or processing circuitry (not shown) configured to perform, conduct or initiate various operations. The processing circuitry may comprise hardware and/or the processing circuitry may be controlled by software. The hardware may comprise analog circuitry or digital circuitry, or both analog and digital circuitry. The digital circuitry may comprise components such as application-specific integrated circuits (ASICs), field-programmable arrays (FPGAs), digital signal processors (DSPs), or multipurpose processors. The device may further comprise memory circuitry, which stores one or more instruction(s) that can be executed by the processor or by the processing circuitry, in particular under control of the software. For instance, the memory circuitry may comprise a non-transitory storage medium storing executable software code which, when executed by the processor or the processing circuitry, causes the various operations of the device to be performed. In one embodiment, the processing circuitry comprises one or more processors and a non-transitory memory connected to the one or more processors.

The present disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. A memory structure (10), comprising:
a substrate (11);
an electrode pair (12-1, 12-2) which is arranged on the substrate (11); and
a metamaterial structure (13) which is arranged between the electrodes of the electrode pair (12-1, 12-2);
wherein the metamaterial structure (13) comprises at least two different materials (14, 15) which are alternately arranged in a periodic pattern; and
wherein the metamaterial structure (13) is electrically excitable to two different memory states due to at least one of its at least two materials (14, 15) undergoing an at least partially reversible change of its structural and/or electrical properties in dependence of a bias voltage being applied to the electrode pair (12-1, 12-2).

2. The memory structure (10) of claim 1,
wherein the metamaterial structure (13) comprises a layer stack of at least two layers, wherein each layer of the layer stack comprises a one-dimensional or two-dimensional pattern of the at least two materials (14, 15).

3. The memory structure (10) of claim 2,
wherein each two successive layers of the layer stack are offset from each other and/or rotated to each other with respect to their patterns.

4. The memory structure (10) of any one of the preceding claims,
wherein the at least two materials (14, 15) of the metamaterial structure (13) are dielectric materials.

5. The memory structure (10) of any one of the preceding claims,
wherein the at least two materials (14, 15) of the metamaterial structure (13) comprise a metal oxide material and/or a silicon nitride material.

6. The memory structure (10) of any one of the preceding claims,
wherein only one of the at least two materials (14, 15) of the metamaterial structure (13) undergoes the at least partially reversible change of its structural and/or electrical properties in dependence of the bias voltage being applied to the electrode pair (12-1, 12-2).

7. The memory structure (10) of any one of the preceding claims,
wherein the at least partially reversible change of its structural and/or electrical properties in the at least one of the at least two materials (14, 15) comprises a formation and/or an interconnection of conducting filaments (25) in the material.

8. The memory structure (10) of claim 7,
wherein the conducting filaments (25) form a path between the electrodes of the electrode pair (12-1, 12-2);
wherein in a first memory state of the two memory states of the metamaterial structure (13), the path is continuous, and in a second memory state of the two memory states of the metamaterial structure (13), the path is interrupted and/or at least partially dissolved.

9. The memory structure (10) of claim 8,
wherein each section of the at least one of the at least two materials (14, 15) is arranged to overlap with at least one adjacent section of the same material, such that the continuous path extends from one electrode of the electrode pair (12-1, 12-2) to the other electrode of the electrode pair (12-1, 12-2).

10. The memory structure (10) of any one of the preceding claims,
wherein the two memory states of the metamaterial structure (13) are associated with two different electrical resistances of the metamaterial structure.

11. A method of fabricating a memory structure (10), comprising the steps of:
forming a first electrode (12-1) of an electrode pair (12-1, 12-2) on a substrate (11);
forming a metamaterial structure (13) on the first electrode (12-1), wherein the metamaterial structure (13) comprises at least two different materials (14, 15) which are alternately arranged in a periodic pattern; and
forming a second electrode (12-2) of the electrode pair (12-1, 12-2) on the metamaterial structure (13);
wherein the metamaterial structure (13) is electrically excitable to two different memory states due to at least one of its at least two materials (14, 15) undergoing an at least partially reversible change of its structural and/or electrical properties in dependence of a bias voltage being applied to the electrode pair (12-1, 12-2).

12. The method of claim 11,
wherein the metamaterial structure (13) is formed by a stacking of layers, wherein each layer comprises a one-dimensional or two-dimensional pattern of the at least two materials (14, 15).

13. The method of claim 12,
wherein each two successive layers are offset from each other and/or rotated to each other with respect to their patterns.

14. The method of claim 12 or 13,
wherein each layer is formed by:
- depositing a uniform layer of one material of the at least two materials (14, 15);
- patterning the uniform layer to generate periodic gaps in the layer; and
- filling the periodic gaps with a further one of the at least two materials (14, 15).

15. The method of any one of claims 11 to 14,
wherein the metamaterial structure (13) and the second electrode (12-2) are subsequently formed on the first electrode (12-1).

16. The method of any one of claims 11 to 14,
wherein the metamaterial structure (13) and the second electrode (12-2) are formed on a further substrate (16) and subsequently transferred to the substrate (11) by means of a wafer bonding step.
